# EUROPÄISCHE PATENTSCHRIFT

(11) **EP 2 579 700 B1**
(45) Veröffentlichungstag und Bekanntmachung des Hinweises auf die Patenterteilung: **06.04.2016**
(21) Anmeldenummer: 12186895.4
(22) Anmeldetag: 01.10.2012
(51) Int. Cl.: H05K 13/04, H05K 13/08

(54) **Bauelement-Haltevorrichtung mit an einer Innenwand angebrachten Markierung**
Construction element holding device with marking applied to an inner wall
Dispositif de support de composant avec un marquage apposé sur une paroi intérieure

(30) Priorität: 04.10.2011 DE 102011083987
(43) Veröffentlichungstag der Anmeldung: 10.04.2013
(73) Patentinhaber: ASM Assembly Systems GmbH & Co. KG, 81379 München (DE)
(72) Erfinder: Brodt, Michael, 82256 Fürstenfeldbruck (DE); Treiber, Marco, 85221 Dachau (DE)
(74) Vertreter: Dilg, Haeusler, Schindelmann Patentanwaltsgesellschaft mbH

(56) Entgegenhaltungen:
- JP-A- 2006 351 682
- US-B1- 6 735 856

## Beschreibung

Die vorliegende Erfindung betrifft allgemein das technische Gebiet der Bestücktechnik. Die vorliegende Erfindung betrifft insbesondere eine Haltevorrichtung für Bauelemente, welche einen Verbindungsabschnitt, in welchem ein Hohlraum ausgebildet ist und welcher an einem Bestückkopf anbringbar ist, und einen Spitzenabschnitt aufweist, welcher an dem Verbindungsabschnitt angebracht ist und welcher einen Saugkanal aufweist, der entlang einer Längsachse der Haltevorrichtung ausgebildet ist und der mit dem Hohlraum des Verbindungsabschnitts verbunden ist, so dass bei einem Anlegen eines Unterdrucks in dem Hohlraum ein Bauelement an einer dem Verbindungsabschnitt abgewandten Stirnfläche des Spitzenabschnitts ansaugbar ist. Die vorliegende Erfindung betrifft ferner ein Verfahren zum Identifizieren des Typs einer Haltevorrichtung.

Die Bestückung von Bauelementträgern mit elektronischen Bauelementen wird üblicherweise in sog. Bestückautomaten durchgeführt. In Bestückautomaten werden die elektronischen Bauelemente mit Hilfe von Bauelement-Haltevorrichtungen, sog. Pipetten, von Bauelement-Zuführeinrichtungen abgeholt, zum Bauelementträger transportiert und dort an den vorgesehenen Stellen aufgesetzt. An ihrer Spitze weist eine Pipette eine Öffnung oder einen Kanal auf, durch die bzw. durch den Luft eingesaugt wird. Berührt die Spitze einer Pipette ein elektronisches Bauelement, so bleibt es durch den entstehenden Unterdruck (häufig auch als Vakuum bezeichnet) an der Stirnseite der Pipette haften und kann transportiert werden. Für einen sicheren Bauelementtransport sind je nach Größe und Gewicht des jeweiligen Bauelements unterschiedliche Typen von Pipetten notwendig, welche sich u.a. durch unterschiedliche Kanalgeometrien auszeichnen. So gibt es beispielsweise Pipetten, bei denen sich der Kanal in Richtung zu der Pipettenspitze in mehrere Einzelkanäle verzweigt, so dass ein Bauelement an mehreren unterschiedlichen Stellen von dem Unterdruck angesaugt wird. Wird ein falscher Pipettentyp verwendet, kann das dazu führen, dass das Bauelement nicht genügend an der Pipette haftet und während des Transports verrutscht oder ganz verloren geht. Ein Verrutschen des elektronischen Bauelements während des Transport führt typischerweise dazu, dass das betreffende Bauelement nicht an der korrekten Bestückposition auf den zu bestückenden Bauelementträger aufgesetzt wird. Ein verlorenes Bauelement wird typischerweise als Ausschuss behandelt und erfordert die erneute Aufnahme es Bauelements desselben Typs. Es ist jedoch auch möglich, dass ein verlorenes Bauelement auf einen zu bestückenden Bauelementträger fällt und in einem nachfolgenden Lötvorgang versehentlich mit verlötet wird, so dass im Ergebnis eine gesamte auf dem Bauelementträger hergestellte elektronische Baugruppe fehlerhaft ist. Zur Verbesserung der Bestückgenauigkeit bzw. der Ausfallsicherheit ist es also erforderlich, dass bei einem Bestückvorgang stets die Verwendung des korrekten Pipettentyps sichergestellt ist.

Bei der Bestückung von Schaltungsträger mittels bekannter Bestückautomaten ist typischerweise eine Bedienperson dafür verantwortlich, um die Verwendung von korrekten Pipettentypen sicher zu stellen. Dazu muss die Bedienperson darauf achten, dass sog. Pipettenmagazine, von welchen ein Bestückkopf des Bestückautomaten die Pipetten aufnimmt, stets richtig befüllt sind. Bei bestimmten Bestückautomaten ist es zudem möglich, den jeweiligen Pipettentyp anhand einer Überprüfung der Pipettenlänge, der Vakuumwerte oder bei einem optischen Vermessen der Pipetten-Stirnfläche automatisch zu erkennen. Diese Überprüfungen können aber entweder nicht für alle Pipettentypen durchgeführt werden und/oder die verschiedenen Pipettentypen unterscheiden sich in den entsprechenden Werten nicht hinreichend. Außerdem ist bei einer falsch aufgenommenen Pipette keine Aussage möglich, um welchen Pipettentyp es sich anstatt des korrekten Pipettentyps handelt. Um also eine möglichst hohe Prozesssicherheit zu erlangen, muss die Bedienperson die Befüllung der Pipettenmagazine selbst zu überprüfen. Dies kann beispielsweise anhand von Farbcodierungen oder Nummern auf den Pipetten erfolgen, was aber in der Regel recht fehleranfällig ist.

Aus US 7,488,283 B2 ist eine automatische Erkennung eines Typs von Pipetten anhand eines auf einem Teller der Pipette aufgebrachten 2D Barcodes (QR-Code) bekannt. Dabei wird der 2D Barcode von einer Kamera erfasst, wenn die Pipette zusammen mit einem zu bestückenden Schaltungsträger in den Bestückautomaten transportiert wird. Diese Art der Pipetten-Erkennung stellt jedoch lediglich einen Spezialfall dar, da sich in der Regel die Pipetten an fest vorgesehen Stellen in sogenannten Pipettenmagazinen befinden und nicht mit dem zu bestückenden Schaltungsträger mittransportiert werden.

Aus JP 2002280798 A ist eine automatische Bestimmung des Pipettentyps bekannt, bei der ein auf einer Oberseite der Pipette aufgebrachter "Code" mit einer Kamera erfasst und der Pipettentyp anhand des erfassten Codes bestimmt wird.

Aus JP 2006 351682 A ist eine Pipette zum Halten von elektronischen Bauelementen bekannt. Die Pipette weist entlang ihrer Längsachse einen unteren Abschnitt, einen Zwischenabschnitt und einen Verbindungsabschnitt auf. Mit dem unteren Abschnitt kann ein elektronisches Bauelement gehalten werden. Mit dem Verbindungsabschnitt kann die Pipette an einer Pipettenhalterung eines Bestückkopfes angebracht werden. Der Zwischenabschnitt weist eine invertierte konische Form auf. An einer Außenwand des Zwischenabschnitts ist ein Identifizierungssymbol angebracht.

Aus US 6,735,856 B1 ist eine Bestückvorrichtung bekannt, welche einen sog. Pipettenwechsler hat, in dem eine Mehrzahl von unterschiedlichen Typen von Pipetten bereitgehalten wird. Eine für einen Bestückungsprozess verwendete Pipette kann in automatischer Weise während des Bestückbetriebs gegen eine bereit gehaltene neue Pipette ausgetauscht werden. Eine eindeutige Zuordnung der neuen Pipette erfolgt mittels einer Kamera, welche an einem Bestückkopf angebracht ist. Mittels der Kamera können Typinformationen der bereit gehaltenen Pipetten erfasst werden. Auf diese Weise kann sichergestellt werden, dass eine korrekte neue Pipette von dem Bestückkopf aufgenommen wird.

Der vorliegenden Erfindung liegt die Aufgabe zugrunde, die automatische Erkennung von Pipetten zu verbessern.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Gemäß einem ersten Aspekt der Erfindung wird eine Haltevorrichtung für Bauelemente, insbesondere für elektronische Bauelemente zum Zwecke der Bestückung von Bauelementträgern mit den elektronischen Bauelementen, beschrieben. Die beschriebene Haltevorrichtung weist auf (a) einen Verbindungsabschnitt, in welchem ein Hohlraum ausgebildet ist und welcher an einem Bestückkopf anbringbar ist, (b) einen Spitzenabschnitt, welcher mit dem Verbindungsabschnitt verbunden ist und welcher einen Saugkanal aufweist, der entlang einer Längsachse der Haltevorrichtung ausgebildet ist und der mit dem Hohlraum des Verbindungsabschnitts in Fluidkommunikation steht und (c) eine Kontaktfläche an dem Spitzenabschnitt, welche von dem Verbindungsabschnitt abgewandt ist, wobei die Kontaktfläche funktionsbereit ist, ein Bauelement zu halten. Erfindungsgemäß befindet sich an einer Innenwand des Hohlraums eine Markierung, welche konfiguriert ist den Typ der Haltevorrichtung zu kennzeichnen.

Der beschriebenen Haltevorrichtung liegt die Erkenntnis zugrunde, dass eine komfortable und wenig fehleranfällige Überprüfung des Typs einer Haltevorrichtung dadurch erreicht werden kann, dass eine für den jeweiligen Typ von Haltevorrichtung indikative Markierung an der Innenseite des Verbindungsabschnitts angebracht wird. Diese Markierung kann dann bereits vor dem Anbringen der Haltevorrichtung an einem Bestückkopf, z.B. wenn sich die Haltevorrichtung ggf. zusammen mit anderen Haltevorrichtungen desselben und/oder eines anderen Typs in einem Magazin befindet, von einer geeigneten Kamera erfasst und von einer der Kamera nachgeschalteten Datenverarbeitungseinrichtung erkannt und/oder ausgewertet werden.

Bei der beschriebenen Haltevorrichtung ist die Markierung durch ihre Lage an der Innenseite des Verbindungsabschnittes besser insbesondere vor Abnutzung geschützt als eine beispielsweise durch einen Aufkleber realisierte Markierung an der Außenseite einer bekannten Haltevorrichtung.

In diesem Dokument kann unter dem Begriff "Bauelementträger" jeder bestückungsfähige Gegenstand verstanden werden. Bauelementträger sind insbesondere elektronische Schaltungsträger, starre oder flexible Leiterplatten und/oder andere Substrate, welche z.B. ein Halbleitermaterial aufweisen können.

Bauelement-Haltevorrichtungen werden in einem Magazin typischerweise in einer derartigen Orientierung aufbewahrt, dass sich ihr Verbindungsabschnitt oben und der Spitzenabschnitt unten in einer geeigneten Aufnahmeöffnung des Magazins befindet. Somit kann vor dem Start einer Baugruppenproduktion, bei der eine bestimmte Charge von Bauelementträgern mit elektronischen Bauelementen bestückt wird, auf einfache Weise die gesamte tatsächlich vorhandene Haltevorrichtungskonfiguration in einem derartigen Magazin ermittelt werden, indem jeweils der Hohlraum von einer Mehrzahl und bevorzugt von allen von in dem Magazin befindlichen Haltevorrichtungen von einer Kamera aufgenommen auf die entsprechenden Markierungen ausgewertet werden. Somit kann auf einfache und zuverlässige Weise überprüft werden, ob alle Haltevorrichtungen, die für einen bestimmten Bestückungsauftrag, bei dem eine Vielzahl von ggf. verschiedenen Typen von Bauelementen auf einen Typ von Bauelementträger aufgesetzt werden, benötigt werden, auch tatsächlich vorhanden sind. Ferner kann auf einfache und zuverlässige Weise sicher gestellt werden, dass für jeden einzelnen Bestückungsvorgang stets die korrekte Haltevorrichtung verwendet wird.

Zur Aufnahme der Hohlräume der Verbindungsabschnitte kann beispielsweise eine Kamera verwendet werden, welche auch zur Vermessung der zu bestückenden Bauelementträger verwendet werden kann. Eine derartige Kamera, welche häufig auch als Leiterplattenkamera bezeichnet wird, kann insbesondere an einem Bestückkopf eines Bestückautomaten angebracht sein. Dies hat den Vorteil, dass die beschriebene Haltevorrichtung mit einer Kamera zuverlässig erkannt werden kann, welche ohnehin bei einem üblichen Bestückautomaten vorhanden ist. Damit ist auf vorteilhafte Weise keine Hardwaretechnische Anpassung oder Veränderung eines bekannten Bestückautomaten erforderlich, um den Typ einer in diesem Dokument beschriebenen Haltevorrichtung zuverlässig zu erkennen.

Im Vergleich zur Überprüfung der Haltevorrichtungen durch eine Bedienperson bietet die automatische Typermittlung der in diesem Dokument beschriebenen Haltevorrichtung zwei entscheidende Vorteile: Erstens ist die Typermittlung weniger fehleranfällig, da bekannte Haltevorrichtungen aufgrund hoher Ähnlichkeiten untereinander leicht verwechselt werden können und zweitens ist eine Überprüfung durch eine Bedienperson sehr zeitaufwändig und eine automatische Überprüfung somit deutlich komfortabler. Außerdem kann die Bedienperson das Ergebnis der Überprüfung beispielsweise anhand übersichtlicher graphischer Ausgaben in einer Grafischen Benutzeroberfläche (GUI) schnell überblicken und so ggf. zügig und zielgerichtet die Konfiguration bzw. die Rüstung eines Magazins mit Haltevorrichtungen korrigieren. In vielen Fällen wird ein Eingriff der Bedienperson sogar komplett überflüssig, weil zwar die aktuelle Konfiguration bzw. Rüstung nicht einem vorgegebenen Soll-Stand entspricht, aber trotzdem genügend "korrekte" Haltevorrichtungen für die fehlerfreie Abarbeitung eines Bestückauftrags verfügbar sind. In diesem Fall kann, da der jeweilige Typ von Haltevorrichtung zweifelsfrei erkannt wurde, eine Steuereinheit eines Bestückautomaten selbständig alle für den aktuellen Bestückauftrag benötigten Haltevorrichtungen korrekt aufnehmen.

Bei der Verwendung von Haltevorrichtungen der in diesem Dokument beschriebenen Art kann auf besonders einfache und zuverlässige Weise der Typ einer unbekannten Haltevorrichtung ermittelt werden. Bei bereits bekannten Typermittlungen, welche beispielsweise auf einer Überprüfung der Länge oder der Höhe einer Bauelement-Haltevorrichtung oder auf einer Erfassung der Stirnfläche der Spitze der Haltevorrichtung basieren, ist das Ergebnis häufig nicht eindeutig, da z.B. einige Haltevorrichtung-Typen eine gleiche Höhe haben und/oder die Stirnfläche von unterschiedlichen Haltevorrichtungen sehr ähnlich ist. Zudem kann, wie bereits oben erwähnt, häufig nur überprüft werden, ob eine bestimmte Haltevorrichtung einem erwarteten Typ entspricht. Es kann in der Regel aber nicht festgestellt werden, um welchen Typ von Haltevorrichtung es sich handelt wenn die überprüfte Haltevorrichtung nicht zu dem erwarteten Typ gehört.

Gemäß einem Ausführungsbeispiel der Erfindung weist die Markierung eine Mehrzahl von Markierungselementen auf, welche einen Kode darstellen, der für den Typ der Haltevorrichtung eindeutig ist.

Die Verwendung einer einen Kode darstellenden Mehrzahl von Markierungselementen kann den Vorteil haben, dass eine Vielzahl von verschiedenen Typen von Haltevorrichtungen auf einfache und zuverlässige Weise eindeutig gekennzeichnet werden können. Der Kode kann beispielsweise ein Farbkode und/oder ein Höhenkode sein, bei dem die Markierungselemente in Bezug zu einer beliebigen Referenzebene innerhalb des Verbindungsabschnitts um eine oder mehrere Höhenwerte erhöht oder vertieft sind.

Die Verwendung einer einen Kode darstellenden Mehrzahl von Markierungselementen kann ferner den Vorteil haben, dass mittels einer Fehlererkennung und/oder einer Fehlerkorrektur die Erkennungsrobustheit deutlich erhöht werden kann. Eigenschaften von Kodes wie Fehlererkennung und -korrektur können beim Design der Kodes berücksichtigt werden und erhöhen die Robustheit der Erkennung des Typs von Haltevorrichtung.

Gemäß einem weiteren Ausführungsbeispiel der Erfindung ist der Kode ein digitaler Kode.

Ein digitaler Kode kann beispielsweise dadurch realisiert werden, dass das Vorhandensein eines Markierungselements an einer bestimmten Position eine digitale EINS und das Nicht-Vorhandensein eines Markierungselements an einer bestimmten Position eine digitale NULL codiert. Selbstverständlich kann auch umgekehrt das Vorhandensein eine digitale NULL und das Nicht-Vorhandensein eines Markierungselements eine digitale EINS kodieren.

Die Verwendung eines digitalen Kodes hat im Vergleich zu einem komplexeren Kode, bei der beispielsweise ein Markierungselement je nach Ausgestaltung (z.B. Farbe, Höhe, Form, etc.) mehr als zwei Zustände kodieren kann, den Vorteil, dass die entsprechende Markierung besonders einfach an dem Verbindungsabschnitt angebracht bzw. ausgebildet werden kann und dass die Dekodierung des digitalen Kodes besonders zuverlässig oder robust erfolgen kann.

Gemäß einem weiteren Ausführungsbeispiel der Erfindung sind die Markierungselemente entlang eines Kreises mit einem einheitlichen und vorgegebenen Abstand zu der Längsachse angeordnet. Ferner befindet sich jedes Markierungselement in Bezug zu den anderen Markierungselementen an einer unterschiedlichen Winkelposition des Kreises. Dies kann insbesondere bedeuten, dass die Markierungselemente winkelförmig in einem bestimmten radialen Abstand zu der Mitte bzw. zu der Längsachse der Haltevorrichtung an der Innenwand des Hohlraums des Verbindungsabschnitts angebracht sind. Dabei kann die Winkellage der einzelnen Markierungselemente den Kode bestimmen, welcher eindeutig den jeweiligen Typ von Haltevorrichtung kennzeichnet.

Gemäß einem weiteren Ausführungsbeispiel der Erfindung weist die Markierung in Bezug zu einer Referenzebene der Haltevorrichtung eine Mehrzahl von Vorsprüngen und/oder Vertiefungen auf. Die Referenzebene kann insbesondere senkrecht zu der Längsachse der Haltevorrichtung orientiert sein.

Die Vorsprünge, welche in diesem Dokument auch als Markierungselemente bezeichnet werden, können beispielsweise Noppen sein, die an der Oberfläche der Innenwand des Hohlraums des Verbindungsabschnitts angeordnet sind. Die Vertiefungen, welche in diesem Dokument ebenfalls als Markierungselemente bezeichnet werden, können beispielsweise Löcher sein, die in der Oberfläche der Innenwand des Hohlraums des Verbindungsabschnitts ausgebildet sind. Die Markierung kann damit auf besonders einfache Weise, beispielsweise im Rahmen eines Spritzgussprozesses mit geeigneten Werkzeigen bzw. Formen ausgebildet werden.

Gemäß einem weiteren Ausführungsbeispiel der Erfindung weist die Markierung eine Mehrzahl von Vorsprüngen und/oder Vertiefungen auf und die Vorsprünge und/oder die Vertiefungen weisen jeweils einen Flächenabschnitt auf, welcher zumindest annähernd senkrecht zu der Längsachse der Haltevorrichtung orientiert ist.

Wenn sich die beschriebene Haltevorrichtung mit ihrem Spitzenabschnitt nach unten beispielsweise in einem Vorratsmagazin befindet, sind die genannten Flächenabschnitte also waagrechte Flächenabschnitte oder horizontal verlaufende Flächenabschnitte. Da die restlichen Oberflächenabschnitte der Innenwand des Hohlraums typischerweise nicht senkrecht zu der Längsachse der Haltevorrichtung orientiert sind, können die waagrecht oder horizontal verlaufenden Flächenabschnitte der Markierung besonders gut und zuverlässig optisch erfasst werden. Insbesondere können die waagrecht oder horizontal verlaufenden Flächenabschnitte zu einer erhöhten optischen Reflexion führen, so dass sie in einer entsprechenden Bildaufnahme typischerweise als helle Bereiche zu erkennen sind. Im realen Betrieb eines Bestückautomaten führt dies dann zu einer besonders robusten Erkennung des jeweiligen Typs von Haltevorrichtung.

Gemäß einem weiteren Ausführungsbeispiel der Erfindung befindet sich die Markierung an der Innenseite eines konischen Teilabschnitts des Verbindungsabschnitts. Die an der Haltevorrichtung angebrachte Markierung kann damit durch eine optische Inspektion, bei der eine Kamera die Haltevorrichtung mittels einer optischen Abbildung, welche annähernd parallel zu ihrer Längsachse erfolgt, erfasst wird und bei der sich die Kamera auf der dem Verbindungsabschnitt zugewandten Seite der Haltevorrichtung befindet, zuverlässig erkannt werden.

Falls sich die Haltevorrichtung mit ihrem Spitzenabschnitt nach unten in einem Vorratsmagazin befindet, dann kann die Markierung besonders einfach von oben insbesondere von einer Kamera erfasst werden, welche in der Bestücktechnik ansonsten für die Erfassung von Markierungen verwendet wird, die sich an zu bestückenden Bauelementträgern befinden.

Gemäß einem weiteren Ausführungsbeispiel der Erfindung sind der Verbindungsabschnitt und die Markierung als eine einstückige Komponente der Haltevorrichtung ausgebildet. Dies kann den Vorteil haben, dass der Verbindungsabschnitt zusammen mit zumindest der Markierung in einem gemeinsamen Herstellungsprozess hergestellt werden kann. Insbesondere kann bei der Herstellung zumindest des Verbindungsabschnitts der beschriebenen Haltevorrichtung mittels eines Spritzgussverfahrens das entsprechende Spritzwerkzeug so entworfen werden, dass die die Markierung darstellenden Markierungselemente unmittelbar beim Spitzgießvorgang des Verbindungsabschnitts als Teil eines einzigen Arbeitsgangs erzeugt werden.

Die Herstellung von Verbindungsabschnitt und Markierung in einem Arbeitsgang kann den Vorteil haben, dass zur Herstellung der beschriebenen Haltevorrichtung kein zusätzlicher Arbeitsschritt erforderlich ist. Entsprechende Schablonen, Aussparungen oder Erhebungen können vielmehr integraler Bestandteil des Spritzwerkzeugs zur Herstellung der Haltevorrichtung sein. Dies kann nicht nur die Kosten sondern auch die Fehlerwahrscheinlichkeit bei der Identifizierung des Typs einer Haltevorrichtung minimieren. Beispielsweise können keine Fehler durch das versehentliche Aufbringen von falschen Markierungen entstehen.

Gemäß einem weiteren Ausführungsbeispiel der Erfindung sind der Verbindungsabschnitt und der Spitzenabschnitt als getrennte Teile ausgebildet.

Dabei können Verbindungsabschnitt und Spitzenabschnitt bevorzugt aus verschiedenen Materialien gefertigt sein. Beispielsweise kann der Spitzenabschnitt, welcher typischerweise einem höheren Verschleiß unterliegt, aus einem verschleißarmen Material wie z.B. Keramik bestehen. Der Verbindungsabschnitt, welcher an seiner Innenseite die beschriebene Markierung aufweist und welcher typischerweise keinem so großen Verschleiß unterliegt, kann aus einem weniger aufwendigen oder teurem Material wie z.B. einem Kunststoff, insbesondere einem spritzgegossenen Kunststoff bestehen. Der Kunststoff kann z.B. ein Flüssigkristallpolymer (Liquid Crystal Polymer, LCP) Material sein, welches beispielsweise unter dem Markennamen Vectra™ bekannt ist.

Ein Bestückautomat zum automatischen Bestücken von Bauelementträgern mit Bauelementen weist auf (a) eine Kamera zum Aufnehmen eines Bildes, welches zumindest einen Teil einer Haltevorrichtung des oben beschrieben Typs zeigt, wobei in dem Bild die Markierung enthalten ist, welche sich an der der Innenwand des Hohlraums befindet und welche konfiguriert ist den Typ der Haltevorrichtung zu kennzeichnen, und (b) eine Auswerteeinheit zum Erfassen und zum Auswerten der Markierung, welche auf dem Bild erscheint und zum Identifizieren des Typs der Haltevorrichtung basierend auf der ausgewerteten Markierung.

Einem solchen Bestückautomaten liegt die Erkenntnis zugrunde, dass eine Typ-Identifizierung der oben beschriebenen Bauelement-Haltevorrichtung von einem herkömmlichen Bestückautomat auf einfache Weise durchgeführt werden kann, ohne dass ein apparativer Umbau des Bestückautomaten erforderlich ist. Erforderlich ist lediglich, die der Kamera nachgeschaltete Auswerteeinheit dahingehend insbesondere softwaretechnisch zu modifizieren, dass die beschriebene Markierung zuverlässig erfasst und ausgewertet werden kann.

Die Kamera kann derart eingerichtet und innerhalb des Bestückautomaten derart angeordnet sein, dass ein zu bestückender Bauelementträger und/oder ein bereits bestückter Bauelementträger zumindest teilweise von der Kamera erfassbar ist. Die beschriebene Kamera kann demzufolge eine sog. Leiterplattenkamera sein, welche in bekannten Bestückautomaten ohnehin vorhanden ist, um Bauelementträger bzw. Positionsmarken von Bauelementträger zu erfassen, welche Bauelementträger in einen Bestückungsbereich des Bestückautomaten zum Zwecke einer Bestückung eingebracht worden sind. Zum Aufnehmen des Bildes von zumindest einem Teil der Haltevorrichtung ist somit auf vorteilhafte Weise keine zusätzliche Kamera erforderlich.

Ein solcher Bestückautomat kann ferner aufweisen einen Bestückkopf (a) zum Abholen von zumindest einem Bauelement von zumindest einer Bauelement-Zuführeinrichtung, (b) zum Transportieren des zumindest einen abgeholten Bauelements in einen Bestückungsbereich des Bestückautomaten und (c) zum Platzieren des zumindest einen transportierten Bauelements auf einen zu bestückenden Bauelementträger. Dabei ist die Kamera gemeinsam mit Bestückkopf an einer Trägerstruktur angebracht, so dass sich die Kamera zusammen mit dem Bestückkopf bewegt. Dadurch kann die Kamera zusammen mit dem Bestückkopf innerhalb des Bestückautomaten verfahren und an geeignete Stelle zum Zwecke der Aufnahme eines Bildes gebracht werden, ohne dass dafür ein eigenes Positioniersystem für die Kamera erforderlich ist. Insbesondere kann der Bestückkopf so verfahren werden, dass die Kamera oberhalb eines Vorratsmagazins für Haltevorrichtungen verfahren wird, so dass die Markierungen von zumindest einigen der in dem Vorratsmagazin enthaltenen Haltevorrichtungen von der Kamera erfasst werden.

Gemäß einem weiteren Aspekt der Erfindung wird ein Verfahren zum Identifizieren des Typs einer Haltevorrichtung beschrieben, wobei die Haltevorrichtung aufweist (a) einen Verbindungsabschnitt, in welchem ein Hohlraum ausgebildet ist und welcher an einem Bestückkopf anbringbar ist, (b) einen Spitzenabschnitt, welcher mit dem Verbindungsabschnitt verbunden ist und welcher einen Saugkanal aufweist, der entlang einer Längsachse der Haltevorrichtung ausgebildet ist und der mit dem Hohlraum in Fluidkommunikation steht, und (c) eine Kontaktfläche an dem Spitzenabschnitt, welche von dem Verbindungsabschnitt abgewandt ist, wobei die Kontaktfläche funktionsbereit ist, ein Bauelement zu halten. Das beschriebene Verfahren weist auf (a) ein Erfassen einer Markierung, welche sich an einer Innenwand des Hohlraums des Verbindungsabschnitts befindet und welche konfiguriert ist den Typ der Haltevorrichtung zu kennzeichnen, (b) ein Auswerten der erfassten Markierung und (c) ein Identifizieren des Typs der Haltevorrichtung basierend auf der ausgewerteten Markierung.

Auch dem beschriebenen Verfahren liegt die Erkenntnis zugrunde, dass eine komfortable und robuste Überprüfung des Typs einer Haltevorrichtung dadurch erreicht werden kann, dass eine für den jeweiligen Typ von Haltevorrichtung indikative Markierung an der Innenseite des Verbindungsabschnitts angebracht wird. Diese Markierung kann dann bereits vor dem Anbringen der Haltevorrichtung an einem Bestückkopf, z.B. wenn sich die Haltevorrichtung ggf. zusammen mit anderen Haltevorrichtungen desselben und/oder eines anderen Typs in einem (Vorrats)Magazin befindet, von einer geeigneten Kamera erfasst und von einer der Kamera nachgeschalteten Datenverarbeitungseinrichtung erkannt und/oder ausgewertet werden.

Die Markierung kann direkt mittels einer Kamera durch eine geeignete Bildaufnahme erfasst werden, mit welcher zumindest ein Teil der Haltevorrichtung aufgenommen wird. Ebenso kann die Markierung aus einem bereits aufgenommenen Bild extrahiert werden, welches Bild welcher zumindest ein Teil der Haltevorrichtung zeigt.

Es wird darauf hingewiesen, dass Ausführungsformen der Erfindung mit Bezug auf unterschiedliche Erfindungsgegenstände beschrieben wurden. Insbesondere sind einige Ausführungsformen der Erfindung mit Vorrichtungsansprüchen und andere Ausführungsformen der Erfindung mit Verfahrensansprüchen beschrieben. Dem Fachmann wird jedoch bei der Lektüre dieser Anmeldung sofort klar werden, dass, sofern nicht explizit anders angegeben, zusätzlich zu einer Kombination von Merkmalen, die zu einem Typ von Erfindungsgegenstand gehören, auch eine beliebige Kombination von Merkmalen möglich ist, die zu unterschiedlichen Typen von Erfindungsgegenständen gehören.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.
- Figur 1: zeigt eine perspektivische Darstellung eines Bestückautomaten zur Durchführung des Verfahrens zum automatischen Identifizieren des Typs einer Bauelement-Haltevorrichtung.
- Figur 2a: zeigt in einer Längsschnittdarstellung eine aus dem Stand der Technik bekannte Bauelement-Haltevorrichtung.
- Figur 2b: zeigt in einer Längsschnittdarstellung eine Bauelement-Haltevorrichtung gemäß einem Ausführungsbeispiel der Erfindung.
- Figur 3: zeigt eine perspektivische Darstellung einer Bauelement-Haltevorrichtung gemäß einem Ausführungsbeispiel der Erfindung.

Es wird darauf hingewiesen, dass Merkmale bzw. Komponenten von unterschiedlichen Ausführungsformen, die mit den entsprechenden Merkmalen bzw. Komponenten der Ausführungsform nach gleich oder zumindest funktionsgleich sind, mit den gleichen Bezugszeichen oder mit einem anderen Bezugszeichen versehen sind, welches sich lediglich in seiner ersten Ziffer von dem Bezugszeichen eines (funktional) entsprechenden Merkmals oder einer (funktional) entsprechenden Komponente unterscheidet. Zur Vermeidung von unnötigen Wiederholungen werden bereits anhand einer vorher beschriebenen Ausführungsform erläuterte Merkmale bzw. Komponenten an späterer Stelle nicht mehr im Detail erläutert.

Ferner wird darauf hingewiesen, dass die nachfolgend beschriebenen Ausführungsformen lediglich eine beschränkte Auswahl an möglichen Ausführungsvarianten der Erfindung darstellen. Insbesondere ist es möglich, die Merkmale einzelner Ausführungsformen in geeigneter Weise miteinander zu kombinieren, so dass für den Fachmann mit den hier explizit dargestellten Ausführungsvarianten eine Vielzahl von verschiedenen Ausführungsformen als offensichtlich offenbart anzusehen sind.

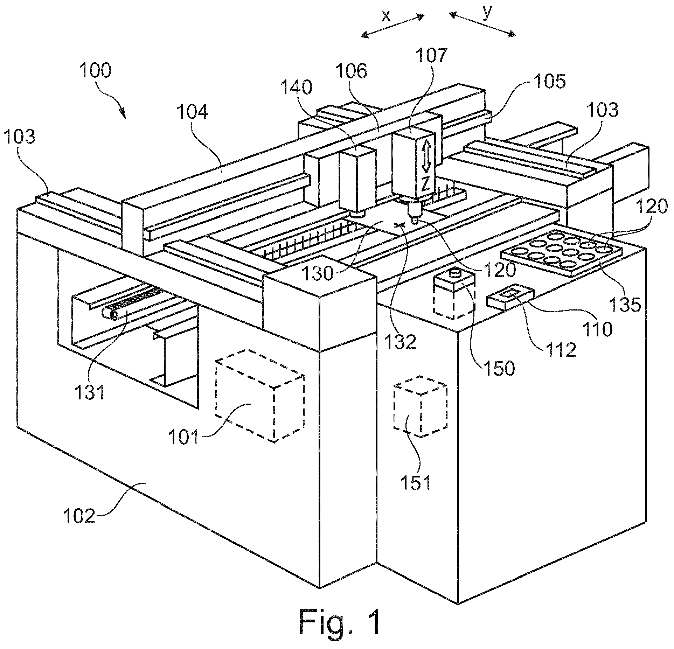

Figur 1 zeigt einen Bestückautomaten 100, welcher einen Rahmen 102 aufweist, an dem zwei parallel ausgerichtete Führungen 103 angebracht sind. Die beiden Führungen 103 tragen einen quer stehenden Trägerarm 104. Der quer stehende Trägerarm 104 weist eine Führung 105 auf, an welcher ein Trägerelement 106 verschiebbar gelagert ist. Die beiden Führungen 103 verlaufen entlang einer γ-Richtung, die Führung 105 verläuft entlang einer x-Richtung. An dem Trägerelement 106 ist ein Bestückkopf 107 angeordnet, welcher zumindest eine als Saugpipette 120 ausgebildete Bauelement-Haltevorrichtung aufweist, die mittels eines nicht dargestellten Antriebs entlang einer zu der x- und zu der γ-Richtung senkrechten z-Richtung verschiebbar ist.

Um die Winkellage von einem aufgenommenen Bauelement zu korrigieren und um somit das Bauelemente nicht nur positionsgenau sondern auch winkelgenau bestücken zu können, ist ferner ein nicht dargestellter Drehantrieb vorgesehen. Mittels des Drehantriebs kann die Bauelement-Haltevorrichtung 120 um ihre Längsachse gedreht werden.

Der Bestückautomat 100 weist ferner eine Bauelement-Zuführeinrichtung 112 auf, mittels welcher in Figur 1 nicht dargestellte Bauelemente dem Bestückungsprozess zugeführt werden können. Ferner umfasst der Bestückautomat 100 ein Förderband 131, mit dem ein zu bestückender Bauelementträger 130 wie z. B eine Leiterplatte 130 in einen Bestückungsbereich des Bestückautomaten 100 eingebracht werden kann. Die Saugpipette 107 kann durch eine entsprechende Bewegung des Bestückkopfes 107 innerhalb der x-y-Ebene innerhalb des gesamten Bestückungsbereichs positioniert werden.

Der Bestückautomat 100 weist außerdem einen Prozessor bzw. eine zentrale Steuereinheit 101 auf. Auf der Steuereinheit 101 kann ein Bearbeitungsprogramm für den Bestückautomaten 100 zum Bestücken von Bauelementeträgern 130 mit Bauelementen ausgeführt werden, so dass alle Komponenten des Bestückautomaten 100 in synchronisierter Weise arbeiten und somit zu einem fehlerfreien und zügigem Bestücken von Bauelementträgern 130 mit Bauelementen beitragen.

An dem Trägerelement 106 ist zusätzlich eine sog. Leiterplatten-Kamera 140 befestigt, welche zur Erfassung einer an der Leiterplatte 130 angebrachten Markierung 132 vorgesehen ist. Auf diese Weise kann die genaue Position der in dem Bestückungsbereich eingebrachten Leiterplatte 130 durch eine Lagevermessung der Markierung 132 innerhalb des Gesichtsfeldes der Leiterplatten-Kamera 140 bestimmt werden.

Zur Positionsvermessung und zur Kontrolle von aufgenommenen Bauelementen ist eine sog. Bauelemente-Kamera 150 vorgesehen, welche gemäß dem hier dargestellten Ausführungsbeispiel in einer festen Position an dem Bestückautomaten 100 angeordnet ist. Die optische Bauelement-Vermessung erfolgt bevorzugt unmittelbar nach der Aufnahme des Bauelements von der Bauelement-Zuführeinrichtung 110 durch eine entsprechende Positionierung des Bestückkopfes 107 oberhalb der Bauelemente-Kamera 150. Das von der Bauelemente-Kamera 150 aufgenommene Bild wird in einer Datenverarbeitungseinrichtung 151 ausgewertet. Dabei wird sowohl eine Erkennung des aufgenommenen Bauelement-Typs als auch eine Positionsbestimmung des aufgenommenen Bauelements durchgeführt. Bei der Positionsbestimmung wird der Versatz des von der Saugpipette 120 aufgenommenen Bauelements relativ zu der Saugpipette 120 bzw. relativ zu dem Bestückkopf 107 ermittelt.

Die Datenverarbeitungseinrichtung 151 kann auch in der zentralen Steuereinheit 101 integriert sein. Dabei kann die Datenverarbeitungseinrichtung 151 mittels einer eigenen Hardware oder auch mittels einer geeigneten Software realisiert sein.

Wie aus Figur 1 ersichtlich, weist der Bestückautomat 100 ferner ein Vorratsmagazin 135 auf, in welchem eine Mehrzahl von Saugpipetten 120 aufbewahrt sind. Da im Verlauf eines Bestückungsauftrags typischerweise verschiedenartige Bauelemente mit unterschiedlichen Größen und Geometrien auf der Leiterplatte 130 aufgesetzt werden, müssen für eine hohe Prozesssicherheit auch jeweils geeignete Saugpipetten 120 verwendet werden. Ein Wechsel zwischen verschiedenen Saugpipetten 120 oder auch ein Austausch einer zumindest zum Teil verschlissenen Saugpipette 120 gegen eine neue oder zumindest eine weniger verschlissene Saugpipette 120 erfolgt dadurch, dass der Bestückkopf 107 über das Vorratsmagazin 135 verfahren wird und die aktuell an dem Bestückkopf 107 befindliche Saugpipette 120 an ein leeres Aufnahmefach in dem Vorratsmagazin 135 übergeben wird. Danach wird der Bestückkopf 107 über die als nächstes aufzunehmende Saugpipette 120 gefahren, so dass diese von dem Bestückkopf 107 aufgenommen werden kann.

Es wird darauf hingewiesen, dass gemäß dem hier beschriebenen Ausführungsbeispiel der Bestückautomat 100 mehrere Bauelement-Zuführeinrichtungen aufweist, welche die unterschiedlichen Typen von Bauelementen dem Bestückungsprozess zuführen. Aus Gründen der Übersichtlichkeit der Darstellung ist in Figur 1 jedoch exemplarisch nur eine Bauelement-Zuführeinrichtung 110 schematisch dargestellt.

Es wird ferner darauf hingewiesen, dass die Erfindung keineswegs auf die Verwendung in dem hier dargestellten Bestückautomaten 100 beschränkt ist. Die Erfindung kann beispielsweise auch mit einer Bauelemente-Kamera realisiert werden, welche zusammen mit dem Bestückkopf verfahren wird und welche dafür vorgesehen ist, die aufgenommenen Bauelemente während des Transports von der Aufnahmeposition hin zu der Bestückposition zu vermessen.

Ebenso kann die Erfindung im Zusammenhang mit einem sog. Mehrfach-Bestückkopf eingesetzt werden, welcher mehrere Haltevorrichtungen aufweist und somit gleichzeitig mehrere Bauelemente transportieren kann. Dabei können die Haltevorrichtungen zeilenförmig oder matrixförmig angeordnet sein. Ebenso können die Haltevorrichtungen jedoch auch um eine Rotationsachse radial abstehend abgeordnet sein, so dass durch eine Drehung der Haltevorrichtungen mehrere Bauelemente sequentiell aufgenommen und auch wieder abgesetzt werden können. Selbstverständlich kann die Erfindung jedoch auch mit beliebigen anderen Arten von Einfach- oder Mehrfach-Bestückköpfen realisiert werden.

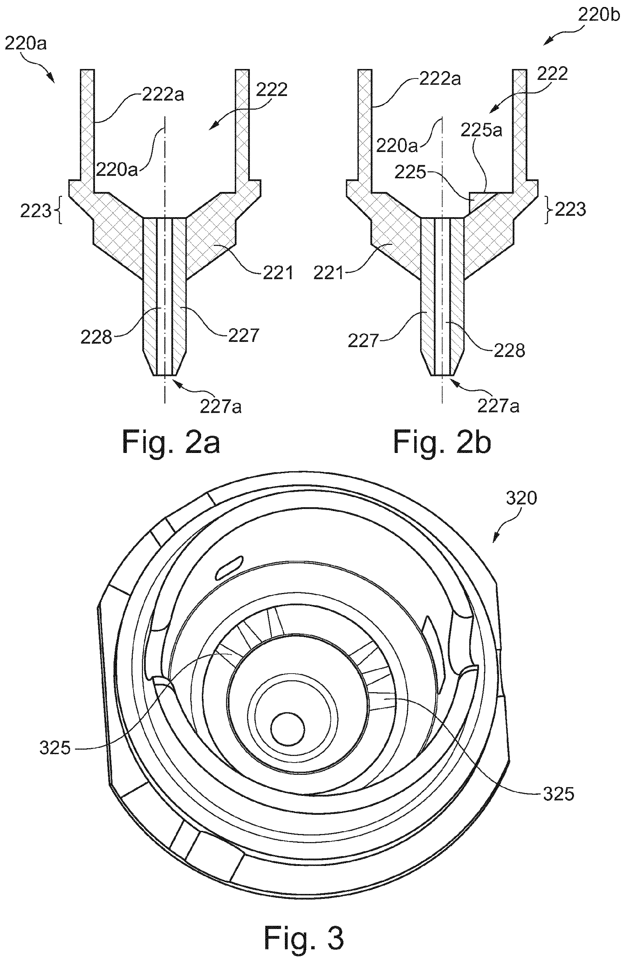

Figur 2b zeigt in einer Längsschnittdarstellung eine Bauelement-Haltevorrichtung 220b gemäß einem Ausführungsbeispiel der Erfindung mit einer Markierung, welche sich an einer Innenwand der Haltevorrichtung befindet. Figur 2a zeigt zum Vergleich eine aus dem Stand der Technik bekannte Bauelement-Haltevorrichtung 220a, welche keine derartige innenliegende Markierung aufweist. Bevor die erfindungsgemäße innenliegende Markierung beschrieben wird, werden zunächst diejenigen Merkmale der Bauelement-Haltevorrichtung 220b beschrieben, welche auch bei der bekannten Bauelement-Haltevorrichtung 220a vorhanden sind.

Die Bauelement-Haltevorrichtung 220b weist einen Verbindungsabschnitt 221 auf, in welchem ein Hohlraum 222 ausgebildet ist. Der Verbindungsabschnitt 221 ist derart ausgestaltet, dass die Haltevorrichtung 220b an einen länglichen hohlen Schaft eines nicht dargestellten Bestückkopfes anbringbar ist. Gemäß dem hier dargestellten Ausführungsbeispiel kann der Verbindungsabschnitt 221 an diesen Schaft einfach aufgesteckt werden, so dass der Schaft in der Figur 2b von oben in das Innere des Hohlraums 222 eingreift und/oder so dass die in der Schnittdarstellung durch zwei nach oben ragende Schenkel dargestellte im Wesentlichen zylinderförmige Ringstruktur umschließt. Der Hohlraum 222 weist eine Innenwand 222a auf. Entlang einer Längsachse 220a der Haltevorrichtung 220b weist der Verbindungsabschnitt 221 einen Teilabschnitt 223 auf, in dem sich der Querschnitt des Hohlraums 222 in Richtung zu einem Spitzenabschnitt 227 der Haltevorrichtung 220b verjüngt. Der Spitzenabschnitt 227 weist einen Saugkanal 228 auf, welcher an seinem dem Verbindungsabschnitt 221 abgewandten Ende an einer Stirnfläche 227a der Haltevorrichtung 220b endet. Sobald der Hohlraum 222 mit einem Unterdruck beaufschlagt wird, entsteht durch den Saugkanal 228 eine Luftströmung, welche dazu führt, dass ein Bauelement, welches an der Stirnfläche 227a anliegt, durch den resultierenden an die Oberfläche des Bauelements übertragenen Unterdruck an der Stirnfläche 227a und damit an der Haltevorrichtung 220b anhaftet.

Wie aus Figur 2b ersichtlich, weist die Bauelement-Haltevorrichtung 220b in dem sich verjüngenden Teilabschnitt 223 an der Innenwand 222a des Hohlraums 222 eine Markierung 225 auf. Die Markierung umfasst mehrere Markierungselemente, welche entlang eines Kreises mit einem einheitlichen und vorgegebenen Abstand zu der Längsachse 220a angeordnet sind. Ferner weist jedes Markierungselement in Bezug zu den anderen Markierungselementen eine unterschiedliche Winkellage auf. In der Schnittdarstellung von Figur 2b ist von der Markierung nur ein Markierungselement 225 zu erkennen. Die Winkellagen der einzelnen Markierungselemente bestimmen dabei einen Kode, welcher eindeutig den Typ der Bauelement-Haltevorrichtung 220b kennzeichnet.

Gemäß dem hier dargestellten Ausführungsbeispiel sind die Markierungselemente 225 Vorsprünge, welche sich von der Innenwand des sich verjüngenden Teilabschnitts 223 nach oben erheben. Um eine gute optische Erkennbarkeit zu erreichen, sind die Vorsprünge 225 derart geformt, dass sie in der durch Figur 2b vorgegebenen Orientierung der Haltevorrichtung 220b jeweils einen waagerechten bzw. horizontalen Flächenabschnitt 225a aufweisen, dessen Oberfläche senkrecht zu der Längsachse 220a verläuft. Bei einer geeigneten Beleuchtung sorgen diese horizontalen Flächenabschnitte 225a dafür, dass vergleichsweise viel Licht zurück reflektiert wird, so dass bei einer Bildaufnahme entlang einer optischen Achse, welche mit der Längsachse 220a zusammenfällt, die horizontalen Flächenabschnitte 225a (im Vergleich zu den dunkler erscheinenden Zwischenräumen) als relativ helle Strukturen deutlich zu erkennen sind.

Es wird darauf hingewiesen, dass anstelle der Vorsprüngeauch Vertiefungen verwendet werden können, um die Markungselemente zu realisieren. Auch die Vertiefungen können derart ausgestaltet sein, dass sich horizontale bzw. waagerechte Flächenabschnitte ergeben, welche zu einer guten optischen Erkennbarkeit der Markierung führen.

Gemäß dem hier dargestellten Ausführungsbeispiel ist die Haltevorrichtung 220b zweistückig ausgebildet. Der Verbindungsabschnitt 221 zusammen mit der Markierung bzw. den Markierungselementen 225 ist als ein Kunststoffteil, welches mittels eines Spritzgießverfahrens hergestellt wurde. Der Kunststoff kann z.B. ein Flüssigkristallpolymer (Liquid Crystal Polymer, LCP) Material sein, welches unter dem Markennamen Vectra™ bekannt ist. Der Spitzenabschnitt 227, welcher üblicherweise einem hohen Verschleiß unterliegt, besteht aus einem harten Keramik-Material.

Figur 3 zeigt eine perspektivische Darstellung einer Bauelement-Haltevorrichtung 320 gemäß einem Ausführungsbeispiel der Erfindung. Von der an der Innenwand der Haltevorrichtung 320 angebrachten Markierung sind die Markierungselemente 325 in der Darstellung von Figur 3 als besonders dunkle Strukturen zu erkennen.

### BEZUGSZEICHENLISTE:

- 100: Bestückautomat
- 101: Prozessor
- 102: Rahmen
- 103: Führungen
- 104: quer stehender Trägerarm
- 105: Führung
- 106: Trägerelement
- 107: Bestückkopf
- 110: Bauelement-Zuführeinrichtung
- 112: Abholposition
- 120: Haltevorrichtung / Pipette / Saugpipette
- 130: Bauelementträger / Leiterplatte
- 131: Förderband
- 132: Markierung
- 135: Magazin / Vorratsmagazin
- 140: Leiterplatten-Kamera
- 150: Bauelemente-Kamera
- 151: Datenverarbeitungseinrichtung
- 220a: Haltevorrichtung / Pipette / Saugpipette
- 220b: Haltevorrichtung / Pipette / Saugpipette
- 220a: Längsachse
- 221: Verbindungsabschnitt
- 222: Hohlraum
- 222a: Innenwand
- 223: verjüngender Teilabschnitt
- 225: Markierung / Markierungselement
- 225a: horizontaler Flächenabschnitt
- 227: Spitzenabschnitt
- 227a: Stirnfläche
- 228: Saugkanal

- 320: Haltevorrichtung / Pipette / Saugpipette
- 325: Markierungselement

## Patentansprüche

1. Haltevorrichtung für Bauelemente, insbesondere für elektronische Bauelemente zum Zwecke der Bestückung von Bauelementträgern (130) mit den elektronischen Bauelementen, die Haltevorrichtung (120, 220b, 320) aufweisend
einen Verbindungsabschnitt (221), in welchem ein Hohlraum (222) ausgebildet ist und welcher an einem Bestückkopf (107) anbringbar ist,
einen Spitzenabschnitt (227), welcher mit dem Verbindungsabschnitt (221) verbunden ist und welcher einen Saugkanal (228) aufweist, der entlang einer Längsachse (220a) der Haltevorrichtung (120, 220b, 320) ausgebildet ist und der mit dem Hohlraum (222) des Verbindungsabschnitts (221) in Fluidkommunikation steht, und
eine Kontaktfläche (227a) an dem Spitzenabschnitt (227), welche von dem Verbindungsabschnitt (221) abgewandt ist, wobei die Kontaktfläche (227a) funktionsbereit ist, ein Bauelement zu halten, wobei sich an einer Innenwand (222a) des Hohlraums (222) eine Markierung (225) befindet, welche konfiguriert ist den Typ der Haltevorrichtung (120, 220b, 320) zu kennzeichnen.

2. Haltevorrichtung gemäß Anspruch 1, wobei
die Markierung eine Mehrzahl von Markierungselementen (225, 325) aufweist, welche einen Kode darstellen, der für den Typ der Haltevorrichtung (120, 220b, 320) eindeutig ist.

3. Haltevorrichtung gemäß Anspruch 2, wobei
der Kode ein digitaler Kode ist.

4. Haltevorrichtung gemäß Anspruch 2 oder Anspruch 3, wobei
die Markierungselemente (225, 325) entlang eines Kreises mit einem einheitlichen und vorgegebenen Abstand zu der Längsachse (220a) angeordnet sind und sich jedes Markierungselement (225, 325) in Bezug zu den anderen Markierungselementen an einer unterschiedlichen Winkelposition des Kreises befindet.

5. Haltevorrichtung gemäß einem Ansprüche 1 bis 4, wobei die Markierung (225, 325) in Bezug zu einer Referenzebene der Haltevorrichtung (120, 220b, 320) eine Mehrzahl von Vorsprüngen und/oder Vertiefungen aufweist, wobei die Referenzebene insbesondere senkrecht zu der Längsachse (220a) der Haltevorrichtung (120, 220b, 320) orientiert ist.

6. Haltevorrichtung gemäß einem der Ansprüche 1 bis 4, wobei die Markierung (225, 325) eine Mehrzahl von Vorsprüngen und/oder Vertiefungen aufweist und die Vorsprünge und/oder die Vertiefungen jeweils einen Flächenabschnitt (225a) aufweisen, welcher zumindest annähernd senkrecht zu der Längsachse (220a) der Haltevorrichtung (120, 220b, 320) orientiert ist.

7. Haltevorrichtung gemäß einem der Ansprüche 1 bis 6, wobei sich die Markierung (225) an der Innenseite eines konischen Teilabschnitts (223) des Verbindungsabschnitts (221) befindet.

8. Haltevorrichtung gemäß einem der Ansprüche 1 bis 7, wobei der Verbindungsabschnitt (221) und die Markierung (225) als eine einstückige Komponente der Haltevorrichtung (120, 220b, 320) ausgebildet sind.

9. Haltevorrichtung gemäß einem der Ansprüche 1 bis 8, wobei der Verbindungsabschnitt (221) und der Spitzenabschnitt (227) als getrennte Teile ausgebildet sind.

10. Verfahren zum Identifizieren des Typs einer Haltevorrichtung (120, 220b, 320), insbesondere einer Haltevorrichtung (120, 220b, 320) gemäß einem der Ansprüche 1 bis 9, wobei die Haltevorrichtung (120, 220b, 320) aufweist (a) einen Verbindungsabschnitt (221), in welchem ein Hohlraum (222) ausgebildet ist und welcher an einem Bestückkopf (107) anbringbar ist, (b) einen Spitzenabschnitt (227), welcher mit dem Verbindungsabschnitt (221) verbunden ist und welcher einen Saugkanal (228) aufweist, der entlang einer Längsachse (220a) der Haltevorrichtung (120, 220b, 320) ausgebildet ist und der mit dem Hohlraum (222) in Fluidkommunikation steht, und (c) eine Kontaktfläche (227a) an dem Spitzenabschnitt (227), welche von dem Verbindungsabschnitt (221) abgewandt ist, wobei die Kontaktfläche (227a) funktionsbereit ist, ein Bauelement zu halten, das Verfahren aufweisend
Erfassen einer Markierung (225, 325), welche sich an einer Innenwand (222a) des Hohlraums (222) befindet und welche konfiguriert ist den Typ der Haltevorrichtung (120, 220b, 320) zu kennzeichnen,
Auswerten der erfassten Markierung (225, 325) und
Identifizieren des Typs der Haltevorrichtung (120, 220b, 320) basierend auf der ausgewerteten Markierung (225, 325).

## Claims

1. Holding device for components, in particular for electronic components for the purpose of assembling component carriers (130) with the electronic components, the holding device (120, 220b, 320) comprising
a connection portion (221)
in which a hollow space (222) is formed and
which is attachable to an assembly head (107),
a head portion (227)
which is connected to the connection portion (221) and
which comprises a suction channel (228)
which is formed along a longitudinal axis (220a) of the holding device (120, 220b, 320) and
which is in fluid communication with the hollow space (222) of the connection portion (221), and
a contact face (227a) at the head portion (227), which contact face (227a) faces away from the connection portion (221), the contact face (227a) being operable to hold a component, wherein
at an inner wall (222a) of the hollow space (222) there is a marking (225) which is configured to indicate the type of the holding device (120, 220b, 320).

2. Holding device according to claim 1, wherein
the marking comprises a plurality of marking elements (225, 325) which represent a code which is unambiguous for the type of the holding device (120, 220b, 320).

3. Holding device according to claim 2, wherein
the code is a digital code.

4. Holding device according to claim 2 or claim 3, wherein
the marking elements (225, 325) are arranged along a circle with a uniform and predetermined distance to the longitudinal axis (220a), and
each marking element (225, 325) is located relatively to the other marking elements at a different angle position of the circle.

5. Holding device according to one of the claims 1 to 4, wherein
the marking (225, 325) comprises relatively to a reference plane of the holding device (120, 220b, 320) a plurality of protrusions and/or recesses, wherein
the reference plane is oriented in particular perpendicular to the longitudinal axis (220a) of the holding device (120, 220b, 320).

6. Holding device according to one of the claims 1 to 4, wherein
the marking (225, 325) comprises a plurality of protrusions and/or recesses, and the protrusions and/or recesses each comprise a face portion (225a) which is oriented at least approximately perpendicular to the longitudinal axis (220a) of the holding device (120, 220b, 320).

7. Holding device according to one of the claims 1 to 6, wherein the marking (225) is located at the inner side of a conical segment (223) of the connection portion (221).

8. Holding device according to one of the claims 1 to 7, wherein
the connection portion (221) and the marking (225) are formed as an integral component of the holding device (120, 220b, 320).

9. Holding device according to one of the claims 1 to 8, wherein
the connection portion (221) and the head portion (227) are formed as separate parts.

10. Method for identifying the type of a holding device (120, 220b, 320), in particular a holding device (120, 220b, 320) according to one of the claims 1 to 9, wherein
the holding device (120, 220b, 320) comprises
(a) a connection portion (221)
in which a hollow space (222) is formed and
which is attachable to an assembly head (107),
(b) a head portion (227)
which is connected to the connection portion (221) and
which comprises a suction channel (228)
which is formed along a longitudinal axis (220a) of the holding device (120, 220b, 320) and
which is in fluid communication with the hollow space (222), and
(c) a contact face (227a) at the head portion (227), which contact face (227a) faces away from the connection portion (221), the contact face (227a) being operable to hold a component, the method comprising
detecting a marking (225, 325)
which is located at an inner wall (222a) of the hollow space (222) and
which is configured to indicate the type of the holding device (120, 220b, 320),
evaluating the detected marking (225, 325), and
identifying the type of the holding device (120, 220b, 320) based on the evaluated marking (225, 325).

## Revendications

1. Dispositif de maintien pour des composants, en particulier pour des composants électroniques afin d'équiper des supports de composant (130) avec les composants électroniques, le dispositif de maintien (120, 220b, 320) présentant
une section de liaison (221), dans laquelle un espace creux (222) est réalisé et qui peut être installée au niveau d'une tête d'équipement (107),
une section de pointe (227), qui est reliée à la section de liaison (221) et qui présente un canal d'aspiration (228), qui est réalisé le long d'un axe longitudinal (220a) du dispositif de maintien (120, 220b, 320) et qui se trouve en communication fluidique avec l'espace creux (222) de la section de liaison (221), et
une surface de contact (227a) au niveau de la section de pointe (227), laquelle est opposée à la section de liaison (221), la surface de contact (227a) étant opérationnelle afin de maintenir un composant, **caractérisé en ce**
**qu'**un marquage (225) se trouve au niveau d'une paroi intérieure (222a) de l'espace creux (222), lequel marquage est configuré pour caractériser le type du dispositif de maintien (120, 220b, 320).

2. Dispositif de maintien selon la revendication 1, **caractérisé en ce**
**que** le marquage présente une pluralité d'éléments de marquage (225, 325), qui constituent un code, qui est représentatif du type du dispositif de maintien (120, 220b, 320).

3. Dispositif de maintien selon la revendication 2, **caractérisé en ce**
**que** le code est un code numérique.

4. Dispositif de maintien selon la revendication 2 ou la revendication 3, **caractérisé en ce**
**que** les éléments de marquage (225, 325) sont disposés le long d'un cercle à une distance uniforme et prédéfinie par rapport à l'axe longitudinal (220a) et chaque élément de marquage (225, 325) se trouve en une position angulaire différente du cercle par rapport aux autres éléments de marquage.

5. Dispositif de maintien selon l'une quelconque des revendications 1 à 4, **caractérisé en ce**
**que** le marquage (225, 325) présente, par rapport à un plan de référence du dispositif de maintien (120, 220b, 320), une pluralité de parties faisant saillie et/ou de renfoncements, le plan de référence étant orienté en particulier de manière perpendiculaire par rapport à l'axe longitudinal (220a) du dispositif de maintien (120, 220b, 320).

6. Dispositif de maintien selon l'une quelconque des revendications 1 à 4, **caractérisé en ce**
**que** le marquage (225, 325) présente une pluralité de parties faisant saillie et/ou de renfoncements et les parties faisant saillie et/ou les renfoncements présentent respectivement une section de face (225a), qui est orientée au moins approximativement de manière perpendiculaire par rapport à l'axe longitudinal (220a) du dispositif de maintien (120, 220b, 320).

7. Dispositif de maintien selon l'une quelconque des revendications 1 à 6, **caractérisé en ce**
**que** le marquage (225) se trouve au niveau du côté intérieur d'une section partielle (223) conique de la section de liaison (221).

8. Dispositif de maintien selon l'une quelconque des revendications 1 à 7, **caractérisé en ce**
**que** la section de liaison (221) et le marquage (225) sont réalisés sous la forme d'un organe d'un seul tenant du dispositif de maintien (120, 220b, 320).

9. Dispositif de maintien selon l'une quelconque des revendications 1 à 8, **caractérisé en ce**
**que** la section de liaison (221) et la section de pointe (227) sont réalisées sous la forme de parties séparées.

10. Procédé servant à identifier le type d'un dispositif de maintien (120, 220b, 320), en particulier un dispositif de maintien (120, 220b, 320) selon l'une quelconque des revendications 1 à 9, **caractérisé en ce que** le dispositif de maintien (120, 220b, 320) présente : (a) une section de liaison (221), dans laquelle est réalisé un espace creux (222) et qui peut être installée au niveau d'une tête d'équipement (107) ; (b) une section de pointe (227), qui est reliée à la section de liaison (221) et qui présente un canal d'aspiration (228), qui est réalisé le long d'un axe longitudinal (220a) du dispositif de maintien (120, 220b, 320) et qui se trouve en communication fluidique avec l'espace creux (222), et (c) une surface de contact (227a) au niveau de la section de pointe (227), qui est opposée à la section de liaison (221), la surface de contact (227a) étant opérationnelle afin de maintenir un composant, le procédé présentant :
la détection d'un marquage (225, 325), qui se trouve au niveau d'une paroi intérieure (222a) de l'espace creux (222) et qui est configuré pour caractériser le type du dispositif de maintien (120, 220b, 320),
l'analyse du marquage (225, 325) détecté, et
l'identification du type du dispositif de maintien (120, 220b, 320) sur la base du marquage (225, 325) analysé.
